# EUROPEAN PATENT SPECIFICATION

(11) **EP 0 321 933 B1**
(45) Date of publication and mention of the grant of the patent: **16.02.1994**
(21) Application number: 88121330.0
(22) Date of filing: 20.12.1988
(51) Int. Cl.: G11C 17/00, G11C 7/00, G07G 1/00

(54) **Device for controlling a Read-only memory, and electronic cash register having such a device**
Steuereinrichtung für einen Nur-Lese-Speicher und damit ausgerüstete elektronische Kasse
Dispositif pour contrôler une mémoire morte, et une caisse électronique ayant un tel dipositif

(30) Priority: 21.12.1987 JP 324860/87
(43) Date of publication of application: 28.06.1989
(73) Proprietor: SHARP KABUSHIKI KAISHA, Osaka 545 (JP)
(72) Inventor: Sakuma, Hideo, Souraku-gun Kyoto (JP)
(74) Representative: TER MEER STEINMEISTER & PARTNER GbR

(56) References cited:
- EP-A- 0 124 092
- US-A- 4 665 328

## Description

### BACKGROUND OF THE INVENTION

### 1. Field of the Invention

The present invention relates to an apparatus for controlling operation needed for writing data into read-only memory after activation of power-supply source when using programmable read-only memory which requires data writing operation using signals having high precision in the time for example.

The term "activation of power-supply source" stated in this description designates supply of power including resumption of power supply after the power supply is momentarily interrupted.

### 2. Description of the Prior Art

Some countries in the world have enforced a system to have commercial stores compulsorily report the sum of sale to the administration in accordance with the system mentioned below. This system obliges commercial stores to write data of total sale into the sealed programmable read-only memory (hereinafter called P-ROM) of an electronic cash register. Sealed P-ROM storing data of total sale is eventually dismounted from the cash register under the presence of administrative officials in charge for implementing compulsory report of the total sale of each store.

When using such an electronic cash register incorporating a P-ROM for storing data, normally, a specific control circuit controls the writing and reading of data into and from the P-ROM. Data written in the P-ROM is stably retained without requiring backup service of battery.

When writing data into P-ROM mainly composed of silicon, the control circuit delivers address signal and data signal designated for storage to P-ROM by means of parallel bit while feeding a high voltage to the P-ROM. The control circuit executes data-writing operation by delivering data-writing instruction signal to the P-ROM, where this signal is durable for the predetermined period of time like 1 millisecond +/-5% for example. If the period of this data-writing instruction signal were shorter than the predetermined period of time, then, the amount of electric charge becomes too short to suffice the needs of the P-ROM. This results in the loss of charge generated for allowing data to be written into the P-ROM, and as a result, it inhibits the system from securely writing logic "1" and "0" into the P-ROM.

Even if the period of the data-writing instruction signal were slightly shorter than the predetermined period of time, even though the term of warranty of the P-ROM were effective for 10 consecutive years in retaining the stored data, the written data may eventually be lost within several years. Conversely, if the period of the data-writing instruction signal were significantly longer than the predetermined period of time, it adversely affects those memory cells in the periphery of the memory cell to be written the data in the P-ROM. This eventually destroys all the data written in those ambient memory cells.

As is clear from the above reason, the control circuit needs to output data-writing instruction signal in an extremely accurate durable period of time. Accordingly, synchronous with clock pulses output from crystal oscillator for example, control circuit executes data-writing operation against the P-ROM by applying data-writing instruction signal having extremely accurate time durability.

Nevertheless, when operating any conventional electronic apparatus incorporating the P-ROM, since the level of oscillated clock pulse is too low immediately after the power is turned ON, control circuit cannot count clock pulses at all, and thus, it outputs a data-writing instruction signal durable for several seconds to the P-ROM.

Normally, any conventional electronic apparatus incorporating a P-ROM withholds to execute data writing operation for a specific period of time like 10 seconds after the power is ON, whereby the level of the oscillated clock pulses is fully stabilized. After this period of activating standby mode, the control circuit is allowed to execute data writing operation.

When writing data using any conventional system as mentioned above, although the period of time until fully stabilizing the oscillated clock pulses is variable according to the condition of using electronic apparatus and the environment in which it is used, allowable maximum period of time must be provided for the standby mode after the power is turned ON, taking those factors in account. As a result, actually even though the oscillated clock pulses are stabilized in a very short period of time, any conventional electronic apparatus incorporating a P-ROM cannot activate operation while the standby mode lasts for such a long period of time as mentioned above. Reflecting this, users anxiously look forward to an early access to a useful electronic apparatus incorporating such a useful P-ROM capable of quickly activating operations after activation of power-supply source.

What was worse, after the power is ON, any conventional electronic apparatus incorporating a P-ROM remains in the standby mode of some while, and thus, it cannot activate any operation other than the operation for writing data into the P-ROM. Consequently, any of those conventional electronic apparatuses mentioned above is still too inconvenient for practical use.

The document EP-A-0 124 092 describes an electronic postage meter having a device for controlling a read-only memory after activation of a power-supply source. This control means monitors an input power signal to provide an output enable signal when the input power signal reaches a first predetermined threshold voltage. Within the time period before the time instant at which said output enable signal is provided, the generation of a write signal is inhibited. Thereby it shall be guaranteed that write operations are always performed correctly.

However, in this prior art electronic postage meter, it is actually not checked whether writing operations can really be performed correctly, but it is only checked whether the input power signal has reached a predetermined threshold voltage. When this voltage is reached, the probability is high that not 100 % of that writing operations will be performed correctly.

It is an object of the invention to provide a device which securely writes data into a read-only memory in a very short period of time after activating a power-supply source. It is a further object to provide an electronic cash register having such a device.

The device of the present invention is defined in claim 1. The electronic cash register of the present invention, using such a device, is defined in claim 5.

The device of the invention checks whether clock pulses which are used for writing data into the read-only memory have surpassed a predetermined threshold level. Only when this condition is fulfilled, data are allowed to be written into the read-only memory. Normally, the clock pulses surpass said threshold rather soon after the power source is switched on, and therefore the delay period, during which a device may not be operated by a user, can be kept very short. As soon as the set condition is fulfilled, it is not only guaranteed that the supply voltage has reached a certain level, but it is also guaranteed that pulses are supplied with a level and therefore with a period of time, being sufficient for properly storing data into said read-only memory.

In a preferred embodiment, means are provided for reading the value counted by the counting means at predetermined time intervals, to identify that the peak level of the first clock pulses is higher than said threshold level when the value counted by said counting means increases.

### BRIEF DESCRIPTION OF THE DRAWINGS

The above and further objects as well as advantageous features of the invention will more fully be apparent from the detailed description and the accompanying drawings that follow.
FIG. 1 is the simplified block diagram of electronic cash register 1 incorporating a preferred embodiment of the read-only memory control system related to the invention;
FIG. 2 is the timing chart designating the operation for writing data into P-ROM 6;
FIG. 3 (1) through (4) are respectively the timing charts designating operations of electronic cash register 1 after activation of power-supply source;
FIG. 4 is the flowchart designating sequential operations of arithmetic processing circuit related to the invention; and
FIG. 5 is the flowchart designating sequential operations of P-ROM control circuit related to the invention.

### DESCRIPTION OF THE PREFERRED EMBODIMENTS

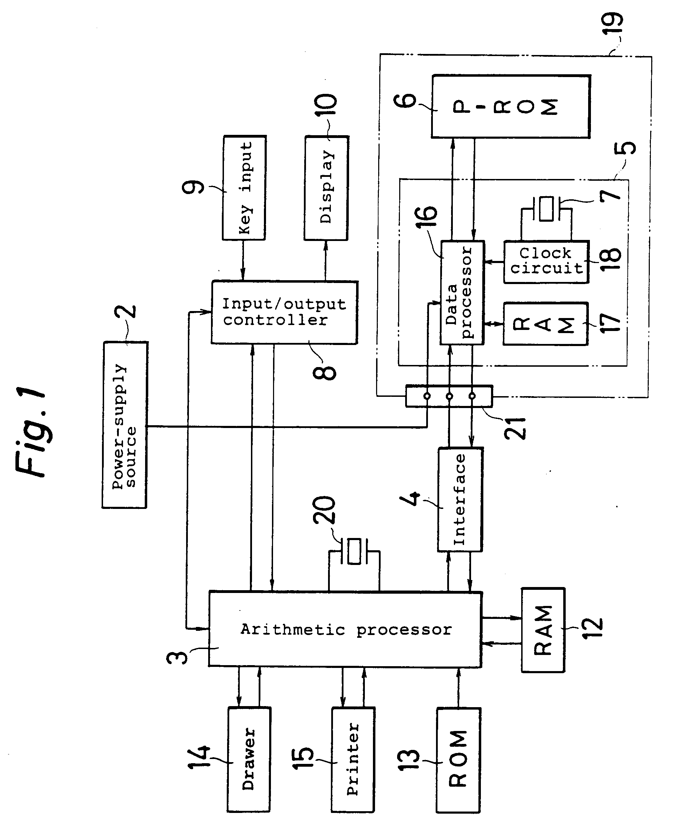

Referring now more particularly to the accompanying drawings, preferred embodiments of the invention are described below. FIG. 1 is the simplified block diagram of electronic cash register 1 incorporating a preferred embodiment of the P-ROM control apparatus according to the invention. Electronic cash register 1 is comprised of P-ROM 6 storing data related to the sales record of a commercial store like a supermarket for example, P-ROM control circuit 5, and arithmetic processing circuit 3, repectively.

P-ROM 6 is substantially composed of silicon and provided with a plurality of cells each storing charge, while each cell also stores data to be written internally. When activating data-writing operation, data signals and address signals are respectively delivered to P-ROM 6 in the form of parallel bits. In this case, a data-writing instruction signal durable for the predetermined period of time like 1 millisecond +/-5% for example is delivered to P-ROM 6. Following the delivery of the data-writing instruction signal to P-ROM 6 for a specific duration and at a specific voltage level, each cell of P-ROM stores the predetermined volume of charge.

P-ROM 6 retains the written data without using backup power supply like battery. However, in order to securely write data into each cell and preserve the data-retentive capability of P-ROM 6 itself, durable period of the data-writing instruction signal must perfectly match the durable period specified for P-ROM in ultrahigh precision.

To correctly deliver the data-writing instruction signal having extremely precise time basis to P-ROM 6, the P-ROM control circuit 5 incorporates the second clock-pulse generating circuit 7 which comprises crystal oscillator for example. Second clock pulses generated by the second clock-pulse generating circuit 7 is delivered to clock circuit 18 which counts the number of the clock pulses. By referring to the number of clock pulses counted by clock circuit 18, arithmetic processing circuit 3 delivers high-precision-time-based data writing instruction signal to P-ROM 6. P-ROM control circuit 5 incorporates random access memory (RAM) 17 which is used as a buffer memory for delivering storable data and address data to P-ROM 6.

Power-supply circuit 2 electrically energizes arithmetic processing circuit 3, P-ROM control circuit 5, and data input/output control circuit 8 of the electronic cash register 1. While carrying on normal cash registration, cash data entered from keyboard 9 is delivered to arithmetic processing circuit 3 via data input/output control circuit 8, so that the entered cash data can be treated with a variety of subsequent processes before eventually being stored in RAM 12. The cash data registered in RAM 12 is then delivered from arithmetic processing circuit 3 to display panel 10 via data input/output circuit 8 before allowing the operator and client to visually confirm the displayed content. Arithmetic processing circuit 3 processes the cash data in accordance with programs stored in ROM 13. P-ROM control circuit 3 controls operation of printer 15 which is provided for printing cash data on receipts for delivery to clients, and opening or closing operation of drawer 14 for receipt or payment of cash. Arithmetic processing circuit 3 operates itself synchronous with the first clock pulse output from the first clock-pulse generating circuit 20. Likewise, time in the input and output of data to and from arithmetic processing circuit 3 is also set synchronous with the first clock-pulse.

Sales data processed by arithmetic processing circuit 3 and stored in RAM 12 is then written into P-ROM 6 by following those steps mentioned below. First, RAM 12 stores sales data for the day together with serial numbers of sales corresponding to each data. For example, these serial numbers respectively have 2-byte data length, whereas each sales data is of 6-byte length. Arithmetic processing circuit 3 then delivers these data signals to data processor 16 of P-ROM control circuit 5 via interface 4 and connector 21, which then stores these 8 byte data signals in RAM 17 and then calculates addresses to be stored in P-ROM 6 by referring to those serial numbers each having 2-byte data length. And data processor 16 generates the flag data which has 2-byte length for example, and designates whether each data has.securely been written into P-ROM 6 or not. To correctly store data of total sales amount for the day in P-ROM 6, a sum of 10 bytes of data are output from this data processor 16 to P-ROM 6. P-ROM 6 and P-ROM control circuit 5 are integrally constituted into a single unit 19, which unit is removably mounted to the arithmetic circuit 3 through a connector 21.

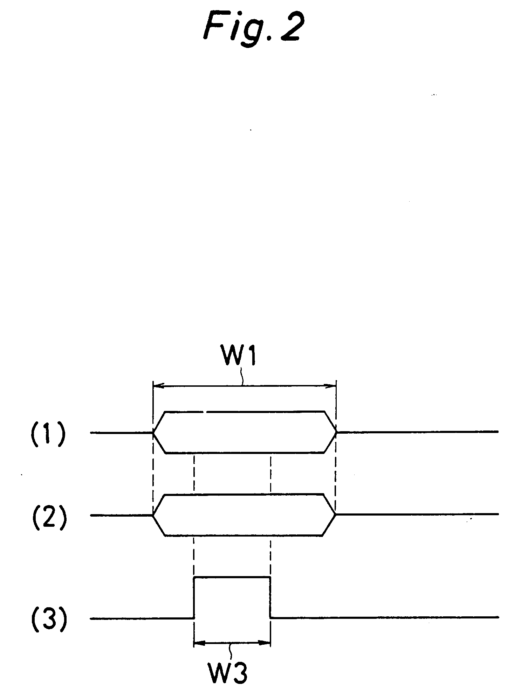

Based on the value counted by clock circuit 18, data processor 16 outputs calculated address signals shown in FIG. 2(1), and storable data signal shown in FIG. 2(2) P-ROM 6 in the form of parallel 8-bits. Accordingly, the apparatus repeatedly executes those sequential processes 10 consecutive times while renewing addresses before eventually storing 10-byte data signals in P-ROM 6. FIG. 2(3) designates data-writing instruction signal generated by the data processor 16. While the data processor 16 retains address signal and data signal in the durable period W1, the data processor 16 generates data-writing instruction signal during a period W3 by referring to the value counted by clock circuit 18. The durable period W3 corresponds to 1 millisecond +/-5% for example. Immediately after activating power-supply source, the level of the second clock pulse generated from the second-pulse generating circuit 7 is too low, and as a result, clock circuit 18 cannot count the clock pulses needed for writing data into P-ROM 6. If this occurs, data processor 16 is prevented from generating data-wiring instruction signal by executing those processes described below.

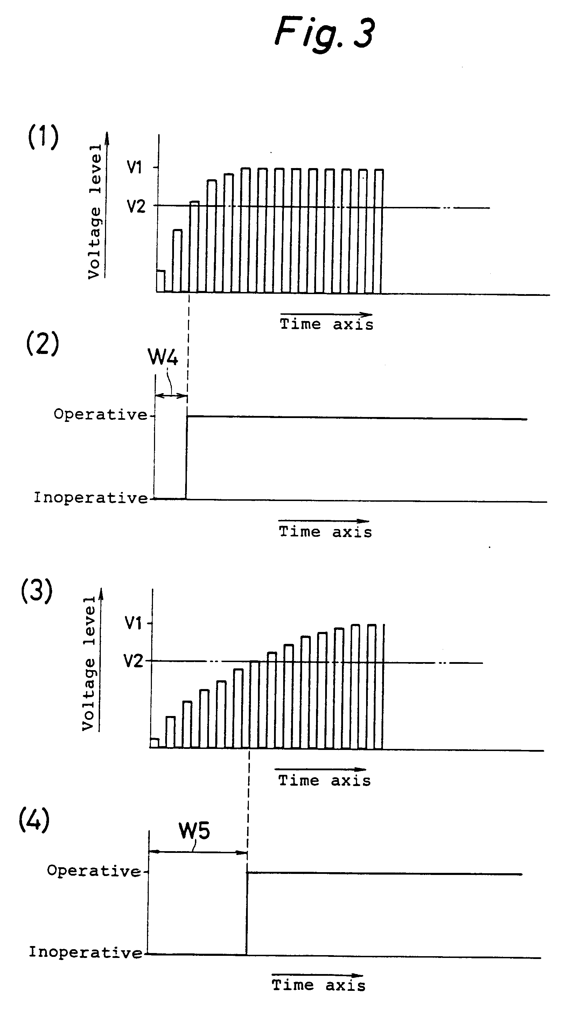

FIG. 3(1) is the waveforms of the first clock pulse output from the first clock-pulse generating circuit 20 immediately after activating power-supply source. After a period W4 is past from the moment of activating power-supply source, the first clock-pulse reaches the threshold level value V2, and then it gradually reaches peak level V1. Accordingly, after a period W4 is past from the activation of power-supply source, arithmetic processing circuit enters into fully operative condition in which it can correctly execute normal input and output operations. This allows arithmetic processing circuit 3 to transmit and receive to and from data processor 16 of P-ROM control circuit 5 synchronous with the first clock-pulse. As a result, after a period W4 is past from the activation of power-supply source, arithmetic processing circuit 3 normally outputs 8-bit data signal to data processor 16 of P-ROM control circuit 5.

FIG. 3(2) is the waveforms of the second clock-pulse output from the second clock-pulse generating circuit 7. The second clock-pulse rises itself at a speed slower than that of the first clock-pulse, and thus, it reaches the threshold level value V2, after a period W5, longer than period W4, is past, and then it gradually reaches peak level V1. Accordingly, after a period W5 is past from the activation of power-supply source, data processor 16 of P-ROM control circuit 5 enters into fully operative condition in which it can correctly write data into P-ROM 6.

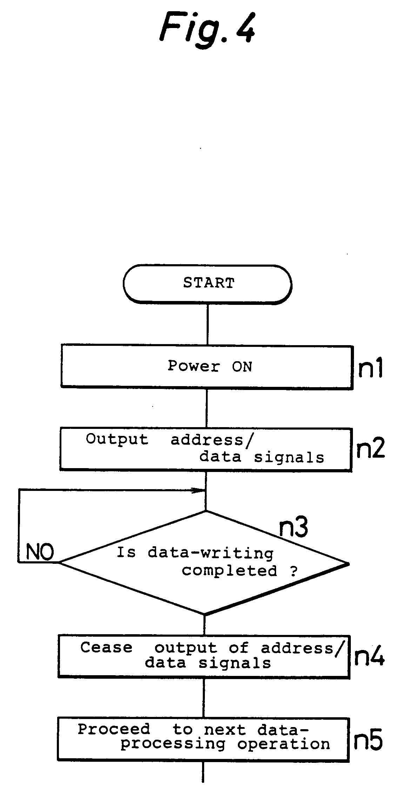

FIG. 4 is the flowchart designating operations of the arithmetic processing circuit 3. While step n1 is underway, if power supply source were activated or power is back from interruption, then, operation mode proceeds to step n2. While step n2 is underway, if the arithmetic processing circuit 3 should write data into P-ROM 6 next for example, then, arithmetic processing circuit 3 outputs 8-bit data signal for example. While step n3 is underway, P-ROM control circuit 5 identifies whether writing of data into P-ROM 6 has already been completed, or not. If it is already completed, P-ROM control circuit 5 outputs data writing-completed signal to the arithmetic processing circuit 3. This activates step n4 is which the arithmetic processing circuit 3 ceases output of all the data signals. Next, when step n5 is activated, in accordance with programs stored in ROM 13, the arithmetic processing circuit 3 resumes the ensuing data processing operations.

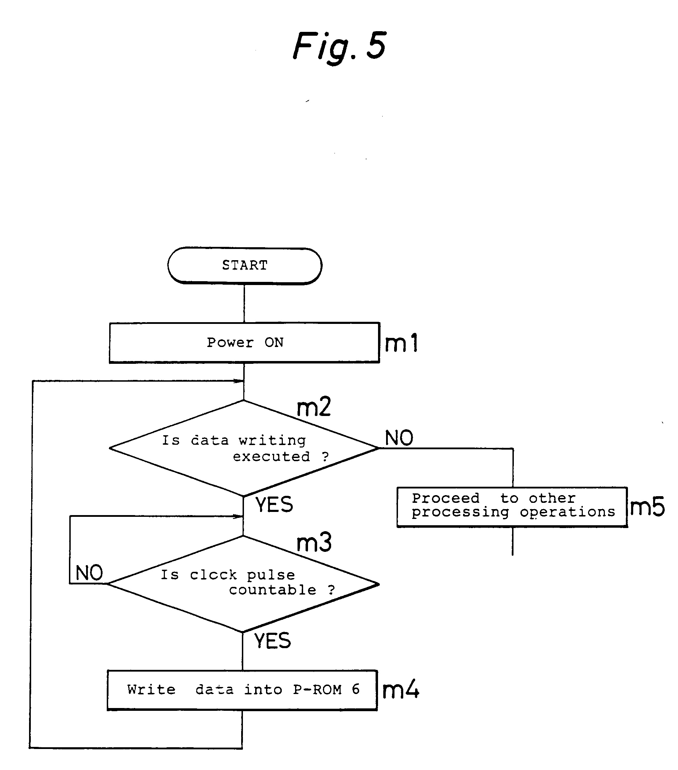

FIG. 5 is the flowchart designating operations of the P-ROM control circuit 5 for writing data into P-ROM 6 on receipt of data from the arithmetic processing circuit 3. In step m1, if the power-supply source turns ON or the power is again back from interruption, while step m2 is underway, then operation mode proceeds to step m2. While step m2 is underway, if data signal from the arithmetic processing circuit 3 should be written into P-ROM 6, then, operation mode enters into step m3. However, if the arithmetic processing circuit 3 outputs signals for reading data from P-ROM 6, for example, then, operation mode proceeds to step m5 in which data processing operation is executed in accordance with the output signals.

While step m3 is underway, P-ROM control circuit 5 identifies whether clock circuit 18 can count the second clock pulses, or not. If the second clock pulse were at a specific peak level higher than the threshold value level V2 (i.e., the predetermined identifying level), clock circuit 18 can count the second clock-pulse. For example, after a certain period W5 is past from the moment of activating power-supply source, clock circuit 18 can count the second clock-pulse. Data processor 16 periodically reads the value counted by clock circuit 18, and as a result, it identifies that the peak value of the second clock-pulse surpasses the threshold value level V2 by detecting variation of the value counted by clock circuit 18.

As soon as the peak level of the second clock pulse surpasses the threshold value level V2, operation mode proceeds to step m4 to allow the data processor 16 to write data into P-ROM 6. Simultaneously, data processor 16 of P-ROM control circuit 5 outputs data-writing instruction signal based on the accurate timing W3 by calculating the value of the second clock-pulse counted by clock circuit 18. When all the needed operations designated for step m4 are terminated, operation mode returns to step m2 to cause this apparatus to repeatedly execute the same data processing operations as was done before.

As is clear from the above description, even in such a period immediately after activating power-supply source, electronic cash register reflecting the preferred embodiment of the invention can freely execute all the data processing operations except for the writing of data into P-ROM 6, and thus, this electronic cash register can securely execute data-writing operation in a certain period of time shorter than the compulsory standby period needed for any conventional apparatus. Furthermore, since the second clock-pulse generating circuit 7 is provided independent of the first clock-pulse generating circuit 20, which delivers the first clock pulses to other circuits, compared to the case that the second clock pulses are generated by drawing out lead wires from the first clock generating circuit 20 to write the data into P-ROM 6, it is eliminates that the fear of lowering time-basis accuracy caused by lag of time basis generated by floating capacitance. Furthermore, discretely provided second clock-pulse generating circuit 7 significantly promotes resistance against noise, thus allowing the P-ROM control circuit 5 to stably write data into P-ROM 6.

The invention allows those preferred embodiments to use P-ROM 6 which is substantially composed of either a bipolar P-ROM, or an EP-ROM whose content is eraseable on exposure to ultraviolet rays and whose window for receiving ultraviolet rays is molded with a beam-shielding resin, or an EEP -ROM (electrically eraseable programmable read-only memory), for example.

The invention may also be embodied in a variety of ways other than those preferred embodiments cited above without departing from the scope, or essential features of the invention. Therefore, those preferred embodiments cites above are merely illustrative examples. The scope of the invention is explicitly manifested in the following Claims, and thus, the content of the foregoing description does not bind the scope of the invention, but any modification or alteration falling under the scope of the invention shall fully be embraced in the scope of the invention itself.

## Claims

1. A device (5) for controlling a read-only memory (6) in which data is written in accordance with a high precision data-writing instruction signal after activation of a power-supply source, said device comprising:
- a first clock-pulse generating circuit (7) for generating first clock pulses;
- means (18) for counting the first clock pulses output from the first clock-pulse generating circuit (7) when the peak level of the first clock pulses surpasses a predetermined threshold level (V₂), thus indicating that the operation of the first clock-pulse generating circuit (7) is stable; and
- data-writing means (16) for identifying whether said first counting means can count the first clock pulses, and for delivering said high precision data-writing instruction signal to the read-only memory (6) in accordance with the first clock pulses only when the peak level of the first clock pulses is higher than the predetermined threshold level (V₂).

2. A device according to claim 1, comprising a means (3) for reading the value counted by said counting means (18) at predetermined time intervals, to identify that the peak level of the first clock pulses is higher than said threshold level when the value counted by said counting means increases.

3. A device according to claim 1 or claim 2, wherein said read-only memory comprises either an electrically erasable programmable read-only memory or an ultraviolet-erasable programmable read-only memory.

4. A device according to claim 3, wherein said read-only memory comprises an ultraviolet-erasable programmable read-only memory whose window for receiving ultraviolet-rays is molded with a beam-shielding resin.

5. An electronic cash register comprising:
- a read-only memory (6) in which data is written in accordance with the high precision data-writing instruction signal;
- a control device (5) according to one of the preceding claims, for controlling said read-only memory;
- an arithmetic processing means (3) having a second clock-pulse generating circuit (20), for executing arithmetic processing operations in response to second clock pulses output from said second clock-pulse generating circuit, and delivering the data to be stored into said read-only memory;
- wherein after activation of a power-supply source (2) a certain period of time is spent before the peak level of the first clock-pulses surpasses said predetermined threshold level (V₂), whereby after activation of said power supply source and said certain period of time, said arithmetic processing means, securely enters into normal arithmetic processing operations in response to said second clock-pulses.

6. An electronic cash register according to claim 5, wherein said read-only memory (6) and said control means (5) for controlling the read-only memory are integrally constituted into a single unit, which unit is removably mounted to said arithmetic processing means (3) through a connector (21).

## Patentansprüche

1. Vorrichtung (5) zum Steuern eines Festwertspeichers (6), in den Daten gemäß einem Datenschreib-Anweisungssignal hoher Genauigkeit nach dem Aktivieren einer Spannungsversorgung eingeschrieben werden, die folgendes aufweist:
- eine erste Taktimpuls-Erzeugungsschaltung (7) zum Erzeugen erster Taktimpulse;
- eine Einrichtung (18) zum Zählen der von der ersten Taktimpuls-Erzeugungsschaltung (7) ausgegebenen ersten Taktimpulse, wenn der Spitzenwert der ersten Taktimpulse einen vorgegebenen Schwellenwert (V₂) überschreitet, um dadurch anzuzeigen, daß der Betrieb der ersten Taktimpuls-Erzeugungsschaltung (7) stabil ist; und
- eine Datenschreibeinrichtung (16) zum Erkennen, ob die erste Zähleinrichtung die ersten Taktimpulse zählen kann, und um das Datenschreib-Anweisungssignal hoher Genauigkeit an den Festwertspeicher (6) in Übereinstimmung mit den ersten Takimpulsen nur dann auszugeben, wenn der Spitzenwert der ersten Taktimpulse höher als der vorgegebene Schwellenwert (V₂) ist.

2. Vorrichtung nach Anspruch 1, mit einer Einrichtung (3) zum Lesen des von der Zähleinrichtung (18) gezählten Werts in vorgegebenen Zeitintervallen, um zu erkennen, daß der Spitzenwert der ersten Takimpulse höher als der Schwellenwert ist, wenn der von der Zähleinrichtung gezählte Wert zunimmt.

3. Vorrichtung nach Anspruch 1 oder Anspruch 2, bei dem der Festwertspeicher entweder einen elektrisch löschbaren, programmierbaren Festwertspeicher oder einen ultraviolettlöschbaren, programmierbaren Festwertspeicher aufweist.

4. Vorrichtung nach Anspruch 3, bei der der Festwertspeicher einen ultraviolettlöschbaren, programmierbaren Festwertspeicher aufweist, dessen Fenster zum Empfangen von Ultraviolettstrahlen durch ein Strahlung abschirmendes Harz vergossen ist.

5. Elektronische Registrierkasse mit:
- einem Festwertspeicher (6), in den Daten abhängig von einem Datenschreib-Anweisungssignal hoher Genauigkeit eingeschrieben werden;
- einer Steuervorrichtung (5) gemäß einem der vorstehenden Ansprüche, zum Steuern des Festwertspeichers;
- einer Arithmetikverarbeitungseinrichtung (3) mit einer zweiten Taktimpuls-Erzeugungsschaltung (20) zum Ausführen von Arithmetikverarbeitungsvorgängen auf zweite Taktimpulse hin, wie sie von der zweiten Taktimpuls-Erzeugungsschaltung ausgegeben werden, und die die im Festwertspeicher abzuspeichernden Daten ausgibt;
- wobei nach dem Aktivieren einer Spannungsversorgung (2) eine gewisse Zeitspanne verstreicht, bevor der Spitzenwert der ersten Taktimpulse den vorgegebenen Schwellenwert (V₂) übersteigt, wobei nach dem Aktivieren der Spannungsversorgung und nach der bestimmten Zeitspanne die Arithmetikverarbeitungsschaltung sicher in normale Arithmetikverarbeitungsabläufe auf die zweiten Taktimpulse hin eintritt.

6. Elektronische Registrierkasse nach Anspruch 5, bei der der Festwertspeicher (6) und die Steuereinrichtung (5) zum Steuern des Festwertspeichers integral in einer einzigen Einheit ausgebildet sind, die über einen Verbinder (21) austauschbar an der Arithmetikverarbeitungseinrichtung (3) angebracht ist.

## Revendications

1. Dispositif (5) pour la commande d'une mémoire morte (6) dans laquelle des données sont écrites en fonction d'un signal d'instruction d'écriture de données de haute précision après la mise en fonction d'une source d'alimentation, ledit dispositif comprenant :
- un premier circuit générateur d'impulsions d'horloge (7) pour produire des premières impulsions d'horloge ;
- un moyen (18) pour compter les premières impulsions d'horloge produites à partir du premier circuit générateur d'impulsions d'horloge (7) lorsque l'amplitude crête des premières impulsions d'horloge dépasse un niveau de seuil prédéterminé (V2), ce qui indique que le fonctionnement du premier circuit générateur d'impulsions d'horloge (7) est stable ; et
- un moyen d'écriture de données (16) pour déterminer si ledit premier moyen de comptage peut compter les premières impulsions d'horloge, et pour fournir ledit signal d'instruction d'écriture de données de haute précision à la mémoire morte (6) en fonction des premières impulsions d'horloge uniquement lorsque l'amplitude crête des premières impulsions d'horloge est supérieure au niveau de seuil prédéterminé (V2).

2. Dispositif selon la revendication 1, comprenant un moyen (3) pour lire la valeur comptée par ledit moyen de comptage (18) à des intervalles de temps prédéterminés, pour déterminer que l'amplitude crête des premières impulsions d'horloge est supérieure audit niveau de seuil lorsque la valeur comptée par ledit moyen de comptage augmente.

3. Dispositif selon la revendication 1 ou la revendication 2, dans lequel ladite mémoire morte comprend soit une mémoire morte programmable effaçable électriquement soit une mémoire morte programmable effaçable par rayons ultraviolets.

4. Dispositif selon la revendication 3, dans lequel ladite mémoire morte comprend une mémoire morte programmable effaçable par rayons ultraviolets dont la fenêtre pour la réception des rayons ultraviolets est moulée avec une résine de blindage de faisceau.

5. Caisse enregistreuse électronique, comprenant :
- une mémoire morte (6) dans laquelle des données sont écrites en fonction du signal d'instruction d'écriture de données de haute précision ;
- un dispositif de commande (5) selon l'une des revendications précédentes, pour la commande de ladite mémoire morte ;
- une unité de traitement arithmétique (3) ayant un second circuit générateur d'impulsions d'horloge (20), pour l'exécution d'opérations arithmétiques en réponse à des secondes impulsions d'horloge produites à partir dudit second circuit générateur d'impulsions d'horloge, et pour fournir les données à mémoriser dans ladite mémoire morte ;
- dans laquelle, après la mise en fonction d'une source d'alimentation (2), une certaine période de temps s'écoule avant que l'amplitude crête des premières impulsions d'horloge ne dépasse ledit niveau de seuil prédéterminé (V2), et par laquelle, après la mise en fonction de ladite source d'alimentation et après ladite certaine période de temps, ledit moyen de traitement arithmétique procède, en toute sécurité, à des opérations arithmétiques normales en réponse auxdites secondes impulsions d'horloge.

6. Caisse enregistreuse électronique selon la revendication 5, dans laquelle ladite mémoire morte (6) et ledit moyen de commande (5) pour la commande de ladite mémoire morte constituent une seule unité, laquelle unité est montée, de manière amovible, sur ledit moyen de traitement arithmétique (3) par l'intermédiaire d'un connecteur (21).
